# EUROPÄISCHE PATENTSCHRIFT

(11) **EP 2 132 792 B1**
(45) Veröffentlichungstag und Bekanntmachung des Hinweises auf die Patenterteilung: **24.12.2014**
(21) Anmeldenummer: 08715550.3
(22) Anmeldetag: 06.03.2008
(51) Int. Cl.: H01L 33/44, H01L 33/50

(54) **VERFAHREN ZUM HERSTELLEN EINES LUMINESZENZDIODENCHIPS UND LUMINESZENZDIODENCHIP**
METHOD FOR THE PRODUCTION OF A LIGHT-EMITTING DIODE CHIP AND LIGHT-EMITTING DIODE CHIP
PROCÉDÉ DE PRODUCTION D'UNE PUCE À DIODE ÉLECTROLUMINESCENTE, ET PUCE À DIODE ÉLECTROLUMINESCENTE CORRESPONDANTE

(30) Priorität: 26.03.2007 DE 102007014374; 20.04.2007 DE 102007018837
(43) Veröffentlichungstag der Anmeldung: 16.12.2009
(73) Patentinhaber: OSRAM Opto Semiconductors GmbH, 93055 Regensburg (DE)
(72) Erfinder: ALBRECHT, Tony, 93077 Bad Abbach (DE); FISCHER, Helmut, 93138 Lappersdorf (DE); WEININGER, Irene, 93055 Regensburg (DE)
(74) Vertreter: Epping - Hermann - Fischer
(86) Internationale Anmeldenummer: PCT/DE2008/000403
(87) Internationale Veröffentlichungsnummer: WO 2008/116439

(56) Entgegenhaltungen:
- US-A1- 2003 181 122
- US-A1- 2004 166 234
- US-A1- 2006 061 259
- US-A1- 2006 237 734
- US-A1- 2006 255 711
- US-A1- 2007 001 178
- US-B1- 6 635 363

## Beschreibung

Die Erfindung betrifft ein Verfahren zum Herstellen mindestens eines Lumineszenzdiodenchips, der mit einem Lumineszenzkonversionsmaterial versehen ist, das mindestens einen Leuchtstoff aufweist. Ein weiterer Gegenstand der Erfindung ist ein derartiger Lumineszenzdiodenchip selbst.

Diese Patentanmeldung beansprucht die Priorität der deutschen Patentanmeldungen 102007014374.7 und 102007018837.6, deren Offenbarungsgehalt hiermit durch Rückbezug aufgenommen wird.

Der Leuchtstoff ist durch eine von dem Lumineszenzdiodenchip emittierte elektromagnetische Primärstrahlung anregbar und emittiert eine Sekundärstrahlung, wobei die Primärstrahlung und die Sekundärstrahlung unterschiedliche Wellenlängenbereiche aufweisen. Ein gewünschter resultierender Farbort des Bauelements kann beispielsweise durch ein Einstellen eines Mischungsverhältnisses der Primärstrahlung und Sekundärstrahlung eingestellt werden.

In der US 2005/0244993 A1 ist ein Verfahren zur Herstellung von Halbleiterbauelementen offenbart, bei dem ein Lumineszenzkonversionselement direkt auf den Halbleiterkörper aufgebracht wird. Dies hat den Vorteil, dass Leuchtstoffe homogen und in einer wohl definierten Menge auf dem Halbleiterkörper aufgebracht werden können. Dadurch lässt sich ein homogener Farbeindruck des lichtabstrahlenden Halbleiterchips erreichen.

Bei dem Verfahren wird der Halbleiterkörper auf einem Träger montiert, mit elektrisch Kontakten versehen und mit einem Lumineszenzkonversionselement beschichtet. Das Beschichten erfolgt mittels einer geeigneten Suspension, die ein Lösungsmittel aufweist, das nach dem Auftragen entweicht. Alternativ wird der Halbleiterkörper mit einem Haftvermittler beschichtet, auf dem nachfolgend der Leuchtstoff aufgebracht wird.

Die Druckschrift US 6,635,363 offenbart ein Verfahren zur Herstellung einer Phosphorbeschichtung auf einem LED-Chip mit einem selbsteinstellenden Abstand vom LED-Chip, bei dem auf einen LED-Chip ein mittels Licht aushärtbares Material aufgebracht wird, das durch vom LED-Chip erzeugtes Licht teilweise ausgehärtet wird und in das ein Phosphor eingebettet wird.

Die Druckschrift US 2006/0061259 offenbart ein Verfahren zur Herstellung eines lichtemittierenden Halbleiterbauelements mit einer Farbstoffschicht, bei dem ein photostrukturierbarer Film mit einem transparenten Silikon und einem beigemischten Farbstoff auf das Halbleiterbauelement aufgebracht, anschließend zur Formung einer Apertur für ein Bondpad strukturiert und dann ausgehärtet wird

Die Druckschrift US 2003/0181122 offenbart ein Verfahren, bei dem eine LED mit einem Photoresist beschichtet wird, das durch die LED selbst anschließend belichtet wird und auf dem anschießend eine Phosphorschicht aufgebracht und mit der Photoresistschicht ausgehärtet wird.

Es ist eine Aufgabe, ein verbessertes Verfahren zum Herstellen eines Lumineszenzdiodenchips bereitzustellen, der mit einem Lumineszenzkonversionsmaterial versehen ist. Das Verfahren soll insbesondere mit technisch geringem Aufwand und kostengünstig durchführbar sein und verbesserte Möglichkeiten hinsichtlich der Gestaltung des Lumineszenzkonversionsmaterials bieten. Zudem soll ein entsprechender Lumineszenzdiodenchip angegeben werden.

Diese Aufgabe wird durch ein Verfahren oder durch einen Lumineszenzdiodenchip gemäß den unabhängigen Patentansprüchen gelöst. Weitere Ausführungsformen und Weiterbildungen des Verfahrens sind Gegenstand der abhängigen Patentansprüche.

Es wird ein Verfahren angegeben, bei dem ein Grundkörper bereitgestellt wird, der eine Schichtenfolge für den herzustellenden Lumineszenzdiodenchip aufweist, die geeignet ist, eine elektromagnetische Strahlung zu emittieren. Auf zumindest einer Hauptfläche des Grundkörpers wird eine Deckschicht aufgebracht. In die Deckschicht wird mindestens eine Kavität eingebracht. Es wird mindestens ein Leuchtstoff auf die Deckschicht aufgebracht, was insbesondere vor oder nach dem Ausbilden der Kavität erfolgen kann.

In einer Ausgestaltung des Verfahrens ist vorgesehen, dass zwischen zumindest einem Teil des Leuchtstoffs und der Deckschicht eine Haftung ausgebildet oder verstärkt wird.

Der Leuchtstoff liegt in Form von Leuchtstoffpartikeln vor.

Durch das Einbringen von mindestens einer Kavität wird die Deckschicht strukturiert. Dadurch ist es insbesondere möglich, Teile der Deckschicht selektiv zu entfernen. Das Aufbringen des Leuchtstoffs auf die Deckschicht erfolgt bevorzugt nach dem Einbringen mindestens einer Kavität. Alternativ ist es jedoch grundsätzlich auch möglich, die Deckschicht mit aufgebrachtem Leuchtstoff zu strukturieren, das heißt die mindestens eine Kavität auszubilden, nachdem der Leuchtstoff aufgebracht worden ist. Durch das Einbringen der Kavität ist es beispielsweise möglich, eine etwaige auf der Hauptfläche des Chips vorhandene elektrische Kontaktfläche freizulegen oder andere Bereiche der Hauptfläche gezielt von der Deckschicht freizuhalten.

Die Deckschicht ist mit Vorteil geeignet, eine Haftung mit zumindest einem Teil des Leuchtstoffs auszubilden, so dass der Leuchtstoff von der Deckschicht gehalten wird. Falls aufgrund der Beschaffenheit der Deckschicht mit dem Aufbringen des Leuchtstoffs bereits eine Haftung zwischen zumindest einem Teil des Leuchtstoffs und der Deckschicht ausgebildet ist, wird die Haftung nachfolgend verstärkt. Zum Ausbilden oder Verstärken der Haftung zwischen der Deckschicht und dem Leuchtstoff wird der Deckschicht gemäß einer Ausführungsform des Verfahrens Energie zugeführt. Eine Ausgestaltung sieht das Zuführen von thermischer Energie vor.

Gemäß dem Verfahren ist die Deckschicht photostrukturierbar, das heißt die Deckschicht wird in Form eines photosensitiven Materials aufgebracht, das sich aufgrund einer selektiven Belichtung gezielt strukturieren lässt. Die Deckschicht kann positiv oder negativ photostrukturierbar sein, das heißt eine geeignete Belichtung eines Teils der Deckschicht kann entweder die Wirkung haben, dass der belichtete Teil geeignet ist, selektiv entfernt zu werden, oder dass der belichtete Teil bei Entfernen von unbelichteten Teilen im Wesentlichen bestehen bleibt.

Das Einbringen der mindestens einen Kavität in die Deckschicht erfolgt im Fall einer photostrukturierbaren Deckschicht mittels Photostrukturieren. Die Deckschicht ist auf diese Weise mit Vorteil unmittelbar strukturierbar, so dass das Einbringen der Kavität mit geringem technischem Aufwand erfolgen kann. Durch die unmittelbare Strukturierbarkeit der Deckschicht wird zudem auch das Lumineszenzkonversionsmaterial auf technisch einfache Weise mittelbar strukturierbar, wenn der Leuchtstoff durch die Deckschicht gehalten wird. Leuchtstoff, für den keine oder keine ausreichend starke Haftung zur Deckschicht ausgebildet wird, wird nachfolgend mit Vorteil entfernt.

Gemäß einer weiteren Ausführungsform wird die Deckschicht in Form eines flüssigen, härtbaren Stoffs aufgebracht und nach dem Aufbringen des Leuchtstoffs gehärtet. Das Ausbilden oder Verstärken der Haftung zwischen dem Leuchtstoff und der Deckschicht umfasst in diesem Fall bevorzugt das Härten.

Gemäß einer weiteren vorteilhaften Ausführungsform erfolgt das Härten der Deckschicht nach dem Einbringen der Kavität. Alternativ ist es jedoch grundsätzlich auch möglich, die Deckschicht bereits vor dem Einbringen der Kavität zu härten.

Der Leuchtstoff wird gegen die Deckschicht gepresst. Dies kann zum Ausbilden oder Verstärken einer Haftung zwischen Leuchtstoff und Deckschicht dienlich sein. Das Pressen kann nach dem Aufbringen des Leuchtstoffes erfolgen. Alternativ ist es beispielsweise auch möglich, dass das Aufbringen des Leuchtstoffes ein Pressen von diesem gegen die Deckschicht umfasst.

In einer weiteren Ausführungsform des Verfahrens ist der bereitzustellende Grundkörper für eine Mehrzahl von Lumineszenzdiodenchips vorgesehen. Bevorzugt ist der Grundkörper ein Wafer oder ein Träger, auf dem die Schichtenfolge oder mehrere derartiger Schichtenfolgen für die Lumineszenzdiodenchips aufgebracht sind. Der Ausdruck "Wafer" umfasst sowohl ganze Scheiben als auch Teilscheiben wie zum Beispiel Bruch-Scheiben eines Wafers. Das Verfahren lässt sich mit Vorteil kompatibel zu Halbleiterprozessen wie Waferprozessen durchführen. Es lässt sich insbesondere in einen Full-Wafer-Prozess integrieren.

Eine weitere Ausführungsform des Verfahrens sieht vor, die Deckschicht mittels Spin-Coating aufzubringen. Spin-Coating wird in der Fachwelt teilweise auch "Aufschleudern" oder "Rotationsbeschichten" genannt. Dadurch lassen sich auf technisch einfache Weise dünne, gleichmäßige und großflächige Deckschichten ausbilden.

Die Deckschicht weist gemäß einer weiteren Ausführungsform mindestens ein Element aus der Gruppe bestehend aus Spin-On-Glas, Benzocyclobuten und Polyimid auf. Spin-On-Glas wird teilweise auch Spin-On-Oxid genannt. Durch ein Material mit mindestens einem derartigen Element kann die Deckschicht grundsätzlich widerstandsfähig gegenüber UV-Strahlung und gut prozessierbar und strukturierbar ausgebildet werden. Durch die Verwendung derartiger Materialien ist es auch möglich, auf Silikon zu verzichten. Silikon ist häufig schwierig prozessierbar und strukturierbar. Zudem kann es Lösungsmittel ausgasen und eine Gefahr der Querkontamination in der Halbleiterfertigung bilden.

Alternativ ist es jedoch auch möglich, zusätzlich Silikon zu verwenden. Grundsätzlich ist gemäß einer weiteren Ausführungsform zusätzlich oder alternativ vorgesehen, dass die Deckschicht mindestens ein Element aus der Gruppe bestehend aus Silikon und Siloxan aufweist.

Gemäß einer weiteren Ausführungsform wird auf den Leuchtstoff eine weitere Deckschicht aufgebracht. Diese weitere Deckschicht ist in einer Ausgestaltung photostrukturierbar ausgebildet. Mit Vorteil wird auf die weitere Deckschicht ebenfalls der zumindest eine Leuchtstoff aufgebracht. Zusätzlich oder alternativ wird mindestens ein weiterer Leuchtstoff auf die weitere Deckschicht aufgebracht.

Gemäß einer vorteilhaften Ausführungsform erfolgen das Aufbringen der Deckschicht und das Aufbringen des Leuchtstoffs mehrfach in abwechselnder Reihenfolge. Dadurch lässt sich Leuchtstoff kontrolliert in einer gewünschten Menge und/oder Zusammensetzung sowie mit einer gewünschten Homogenität aufbringen.

Die Deckschicht oder die Deckschichten werden gemäß einer weiteren Ausführungsform mit einer maximalen Dicke von größer als 1 µm und kleiner als oder gleich 40 µm ausgebildet. Derart dünne Deckschichten in Kombination mit Leuchtstoff haben den Vorteil, dass sie geringere negative Auswirkungen auf eine zu emittierende Strahlung aufweisen als dickere Schichten. Negative Auswirkungen können beispielsweise Reflexion, insbesondere Totalreflexion oder Absorption der Strahlung sein. Insbesondere kann durch eine dünne Deckschicht die Gefahr verringert werden, dass die Deckschicht als ein Wellenleiter für eine zu emittierende Strahlung wirkt und somit einen signifikanten Anteil der Strahlung an der Auskopplung hindert.

Gemäß einer weiteren Ausführungsform liegt der Leuchtstoff in Form von Leuchtstoffpartikeln mit einem Mediandurchmesser d₅₀ von kleiner als oder gleich 20 µm vor. Zusätzlich oder alternativ weisen die Leuchtstoffpartikel einen Mediandurchmesser d₅₀ von größer oder gleich 2 µm auf. Der Mediandurchmesser wird jeweils anhand einer Anzahlverteilungssumme Q₀ oder anhand einer Volumen- oder Masseverteilungssumme Q₃ ermittelt. Die Ermittlung anhand Q₀ ist bevorzugt.

Es wird ein Lumineszenzdiodenchip angegeben, der durch ein Verfahren gemäß einer der Ausführungsformen hergestellt ist.

Weitere Vorteile, bevorzugte Ausführungsformen und Weiterbildungen des Verfahrens und des Lumineszenzdiodenchips ergeben sich aus den im Folgenden in Verbindung mit den Figuren erläuterten Ausführungsbeispielen. Es zeigen:
- Figuren 1 bis 6: schematische Schnittansichten eines Grundkörpers während verschiedener Verfahrensstadien des Verfahrens gemäß einem ersten Ausführungsbeispiel,
- Figuren 7 und 8: schematische Schnittansichten des Grundkörpers während verschiedener Verfahrensstadien des Verfahrens gemäß eines zweiten Ausführungsbeispiels, und
- Figuren 9 und 10: schematische Schnittansichten des Grundkörpers während verschiedener Verfahrensstadien des Verfahrens gemäß eines dritten Ausführungsbeispiels.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

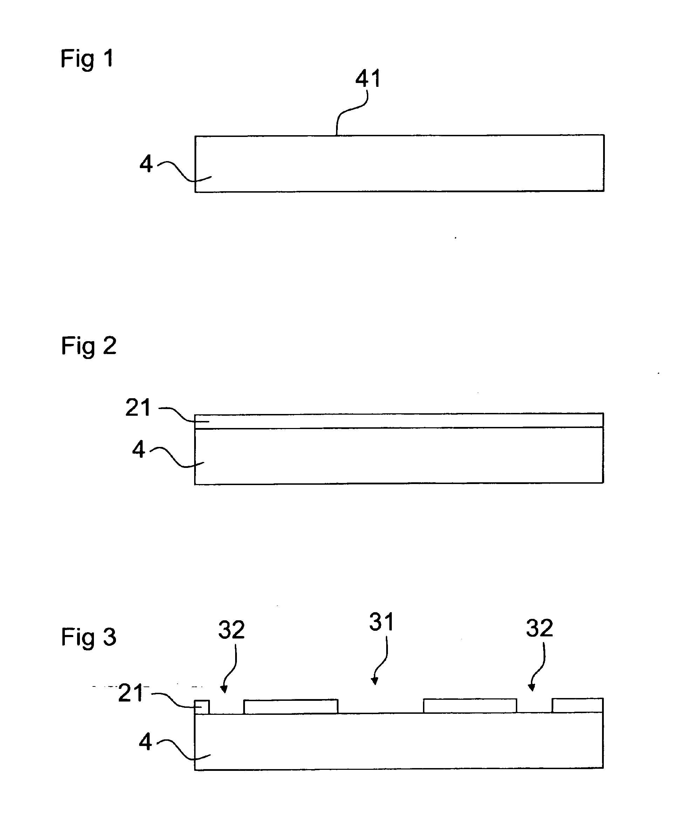

In Figur 1 ist ein Grundkörper 4 dargestellt. Dieser ist geeignet, bei Beaufschlagung mit elektrischem Strom eine elektromagnetische Strahlung zu emittieren. Er weist z.B. einen Träger und eine auf dem Träger aufgebrachte DünnfilmSchicht auf (nicht gezeigt).

Die Dünnfilmschicht basiert beispielsweise auf Nitrid-Verbindungshalbleitermaterialien und weist mindestens einen aktiven Bereich auf, der geeignet ist, die elektromagnetische Strahlung zu emittieren. Die elektromagnetische Strahlung weist beispielsweise Wellenlängen aus dem blauen und/oder ultravioletten Spektrum auf.

Nitrid-Verbindungshalbleitermaterialien sind Verbindungshalbleitermaterialien, die Stickstoff enthalten, wie Materialien aus dem System InₓAl_{y}Ga_{1-x-y}N mit 0 ≤ x ≤ 1, 0 ≤ y ≤ 1 und x + y ≤ 1. Die Dünnfilmschicht weist z.B. mindestens eine Halbleiterschicht aus einem Nitrid-Verbindungshalbleitermaterial auf.

In dem aktiven Bereich des Grundkörpers 4 kann beispielsweise ein herkömmlicher pn-Übergang, eine Doppelheterostruktur, eine Einfach-Quantentopfstruktur (SQW-Struktur) oder eine Mehrfach-Quantentopfstruktur (MQW-Strukur) enthalten sein. Solche Strukturen sind dem Fachmann bekannt und werden von daher an dieser Stelle nicht näher erläutert. Beispiele für solche MQW-Strukturen sind in den Druckschriften US 5,831,277 und US 5,684,309 beschrieben, deren Offenbarungsgehalt insofern hiermit durch Rückbezug aufgenommen wird.

Auf die Hauptfläche 41 des Grundkörpers 4 wird eine Deckschicht 21 aufgebracht, siehe Figur 2. Die Deckschicht 21 besteht beispielsweise aus einem photostrukturierbaren Material oder weist ein derartiges Material auf, so dass sie photostrukturierbar ist. Das Material wird in einem flüssigen Zustand bereitgestellt, beispielsweise als eine Lösung oder eine Emulsion, und ist härtbar. Die Deckschicht wird z.B. mittels eines Spin-Coating Verfahrens in einer ebenen Schicht aufgebracht. Die maximale Dicke der Deckschicht 21 beträgt z.B. 30 µm.

Nachfolgend werden Kavitäten 31, 32 in der Deckschicht ausgebildet (siehe Figur 3), was z.B. mittels Photostrukturieren der Deckschicht erfolgt. Grundsätzlich ist es auch möglich nur eine einzige Kavität auszubilden. Zur Ausbildung von Kavitäten werden die zu entfernenden Teile des photostrukturierbaren Materials belichtet. Selbstverständlich ist es auch möglich, alternativ ein photostrukturierbares Material zu verwenden, bei dem die nicht zu entfernenden Teile beim Photostrukturieren zu belichten sind. Es können grundsätzlich auch unterschiedliche photostrukturierbare Materialien miteinander kombiniert werden. Die Deckschicht 21 wird z.B. in Bereichen, in denen die Kavitäten 31, 32 vorgesehen sind, mittels einer Maske und elektromagnetischer Strahlung einer geeigneten Wellenlänge belichtet.

In einem weiteren Verfahrensschritt wird die belichtete Deckschicht 21 mittels eines für das photostrukturierbare Material geeigneten Mediums entwickelt. Die belichteten Teile der Deckschicht 21 werden entfernt, so dass die Kavitäten 31, 32 ausgebildet werden, siehe Figur 3.

Der Grundkörper 4 ist beispielsweise ein Wafer für eine Vielzahl von Lumineszenzdiodenchips. Der Wafer kann beispielsweise ein Epitaxiesubstrat aufweisen oder auch frei von einem Epitaxiesubstrat sein. Beispielsweise kann eine Dünnfilmschicht des Grundkörpers statt auf einem Epitaxiesubstrat auch auf einem separaten Trägersubstrat angeordnet sein. Die Dünnfilmschicht muss nicht einstückig ausgebildet sein, sondern kann in Form einer Vielzahl separater Teile für eine Vielzahl von Lumineszenzdiodenchips auf dem Träger aufgebracht sein.

Die Dünnfilmschicht weist beispielsweise auf der Hauptfläche 41 für jeden Lumineszenzdiodenchip eine elektrische Kontaktfläche auf (nicht gezeigt). Erste Kavitäten 31 werden beispielsweise für jeden herzustellenden Lumineszenzdiodenchip im Bereich einer solchen elektrischen Kontaktfläche ausgebildet, so dass diese freigelegt wird. Eine zweite Kavität 32 wird beispielsweise in Trennungsbereichen ausgebildet, entlang derer der Grundkörper nach Abschluss des Verfahrens zu der Vielzahl von Lumineszenzdiodenchips zu vereinzeln ist. Die zweite Kavität 32 wird beispielsweise entlang von Sägespuren ausgebildet, so dass die Sägespuren zumindest teilweise freigelegt werden.

Das photostrukturierbare Material für die Deckschicht 21 wird beispielsweise in einem flüssigen Zustand aufgebracht und auch in einem flüssigen Zustand strukturiert, so dass die Deckschicht 21 nach Ausbilden der Kavitäten 31, 32 noch flüssig ist. Unter den Ausdruck "flüssig" fallen in diesem Zusammenhang insbesondere auch zähflüssige Zustände.

Die Deckschicht 4 besteht beispielsweise aus einem photostrukturierbaren Spin-On-Glas. Dieses basiert beispielsweise auf Silsesquioxan und weist Polysiloxanketten als Basiseinheiten auf. Es kann zum Beispiel mit einer UV-Strahlung oder einem sichtbaren Licht vernetzt werden. Derartige photostrukturierbare Spin-On-Gläser sind kommerziell erhältlich. Sie werden in einem flüssigen Zustand aufgebracht und sind mittels Energiezufuhr, beispielsweise mittels Wärmezufuhr, härtbar.

Alternativ kann für die Deckschicht zum Beispiel ein photostrukturierbares Benzocyclobuten (BCB), beispielsweise auf der Basis von Bisbenzocyclobuten. Auch derartige Materialien sind kommerziell erhältlich. Sie lassen sich ebenfalls in einem flüssigen Zustand aufbringen und photostrukturieren und können mittels Energiezufuhr, z.B. Wärmezufuhr, gehärtet werden. Derartige Materialien werden beispielsweise von dem Unternehmen Dow Chemical vertrieben.

Als weitere Alternative kann für die Deckschicht ein photostrukturierbares Polyimid als Material verwendet werden. Auch derartige Materialien sind kommerziell erhältlich, lassen sich in einem flüssigen Zustand aufbringen und strukturieren und können mittels Energiezufuhr gehärtet werden.

Grundsätzlich ist es auch möglich, ein photostrukturierbares Silikon für die Deckschicht zu verwenden. Auch derartige Materialien sind kommerziell erhältlich, in flüssigem Zustand aufbringbar und strukturierbar sowie mittels Wärmezufuhr härtbar. Geeignete Materialien werden beispielsweise von dem Unternehmen Silecs oder Dow Corning vertrieben.

Zum Ausbilden der mindestens einen Kavität 31, 32 wird das jeweilige Material in flüssigem Zustand mit elektromagnetischer Strahlung eines geeigneten Wellenlängenbereichs wie oben beschrieben belichtet und nachfolgend mit einem geeigneten Medium entwickelt. Da die jeweils geeigneten Materialien kommerziell erwerbbar sind, ist dem Fachmann jeweils auch ein geeignetes Medium zum Entwickeln bekannt, so dass darauf an dieser Stelle nicht näher eingegangen wird.

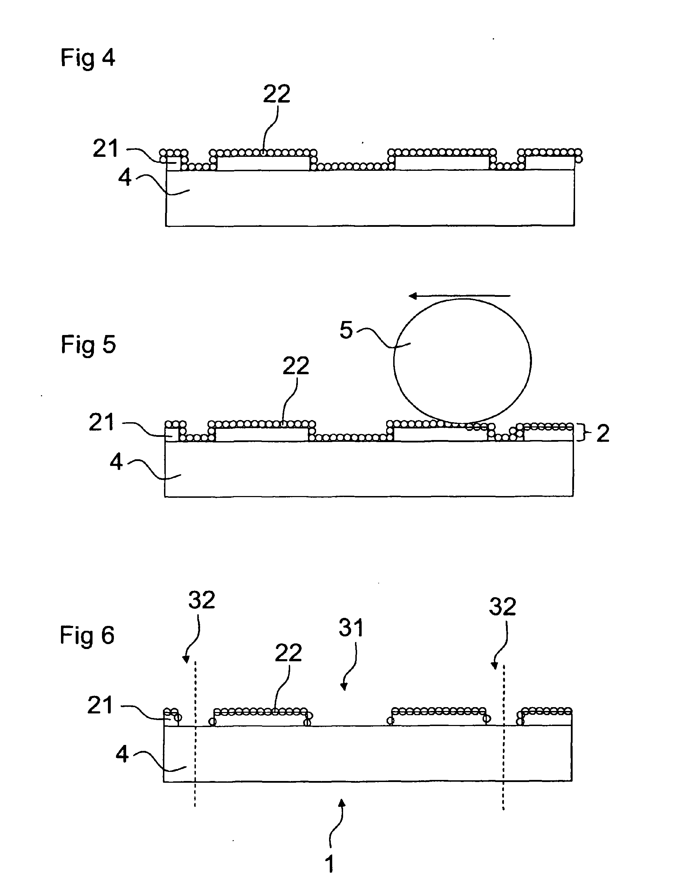

Nachfolgend wird mindestens ein Leuchtstoff 22 in Form von Leuchtstoffpartikeln auf die Deckschicht 21 aufgebracht. Der Leuchtstoff 22 wird beispielsweise aufgestreut, so dass er die Deckschicht 21 in einer Schicht zumindest teilweise bedeckt, siehe Figur 4. Die Leuchtstoffpartikel können in etwa einer Lage oder insbesondere auch in mehreren übereinander liegenden Lagen schichtartig aufgebracht werden, z.B. mittels einmaligen oder mehrfachen Aufstäubens.

Nachfolgend wird der Leuchtstoff 22 gegen die Deckschicht 21 gepresst. Dies erfolgt zum Beispiel mittels einer Walze 5, was in Figur 5 veranschaulicht ist. Dadurch werden die Leuchtstoffpartikel des Leuchtstoffs 22 zumindest teilweise in die Deckschicht 21 hineingedrückt. Zumindest ein Teil der hineingedrückten Leuchtstoffpartikel weist jedoch gemäß einer Ausführungsform eine Teilfläche auf, die von der Deckschicht 21 abgewandt ist, das heißt zumindest ein Teil der Leuchtstoffpartikel wird nicht von der Deckschicht 21 eingeschlossen. Es ist auch möglich, dass im Wesentlichen keines der Leuchtstoffpartikel von der Deckschicht 21 eingeschlossen wird. Das Pressen kann zum Beispiel zusätzlich oder alternativ auch durch Aufdrücken einer im wesentlichen ebenen Pressfläche erfolgen.

Nachfolgend wird die Deckschicht 21 gehärtet, wodurch eine Haftung zwischen den Leuchtstoffpartikeln des Leuchtstoffes 22 und der Deckschicht 21 verstärkt oder auch ausgebildet werden kann. Das Härten erfolgt beispielsweise mittels Ausheizen. Je nach verwendetem Material für die Deckschicht eignen sich Temperaturen in einem Bereich zwischen beispielsweise 150°C und 400°C. Zum Beispiel wird ein Spin-On-Glas verwendet, das bei 200°C ausgeheizt und somit gehärtet wird. Je nach Dauer des Ausheizens kann die Deckschicht somit vollständig ausgehärtet werden, so dass sie nicht mehr flüssig ist. Alternativ ist es jedoch auch möglich, die Deckschicht lediglich teilweise zu härten.

Die Leuchtstoffpartikel des Leuchtstoffes 22 weisen beispielsweise einen Mediandurchmesser d₅₀ von cirka 15 µm auf, wobei d₅₀ zum Beispiel anhand einer Anzahlverteilungssumme Q₀ ermittelt wird. Alternativ weisen die Leuchtstoffpartikel einem Mediandurchmesser d₅₀ von etwa 10 µm auf, wobei d₅₀ anhand einer Volumen- oder Masseverteilungssumme Q₃ ermittelt wird.

Grundsätzlich eignen sich alle für die Anwendung bei LEDs bekannten Leuchtstoffe für die Verwendung im Verfahren. Beispiele für derartige als Konverter geeignete Leuchtstoffe und Leuchtstoffmischungen sind:
- Chlorosilikate, wie beispielsweise in DE 10036940 und dem dort beschriebenen Stand der Technik offenbart,
- Orthosilikate, Sulfide, Thiometalle und Vanadate wie beispielsweise in WO 2000/33390 und dem dort beschriebenen Stand der Technik offenbart,
- Aluminate, Oxide, Halophosphate, wie beispielsweise in US 6,616,862 und dem dort beschriebenen Stand der Technik offenbart,
- Nitride, Sione und Sialone wie beispielsweise in DE 10147040 und dem dort beschriebenen Stand der Technik offenbart, und
- Granate der Seltenen Erden wie YAG:Ce und der Erdalkalielemente wie beispielsweise in US 2004-062699 und dem dort beschriebenen Stand der Technik offenbart.

Nach dem Härten werden Leuchtstoffpartikel des Leuchtstoffes 22, die keine oder keine ausreichend starke Haftung mit der Deckschicht 21 ausgebildet haben, entfernt. Das Entfernen der Leuchtstoffpartikel erfolgt beispielsweise mittels eines Gas- oder Flüssigkeitsstrahls, z.B. mittels eines Luftstrahls oder eines Wasserstrahls. Dadurch werden die Kavitäten 31, 32 im Wesentlichen frei von Leuchtstoff, siehe Figur 6. Die Deckschicht 21 und der Leuchtstoff 22 bilden ein Lumineszenzkonversionsmaterial 2.

Nachfolgend kann der Grundkörper 4 zum Beispiel entlang der zweiten Kavität 32 zu einer Vielzahl von Lumineszenzdiodenchips 1 vereinzelt werden. Dies erfolgt zum Beispiel mittels Sägen. In Figur 6 ist ein möglicher Verlauf einer Sägespur in oder ein sonstiger Trennungsverlauf in vertikaler Richtung anhand von gestrichelten Linien angedeutet. Bei dem Verfahren kann grundsätzlich auch auf Ausnehmungen 32 für Trennungsspuren verzichtet werden.

Wenn die Leuchtstoffpartikel des Leuchtstoffes 22 vor dem Härten der Deckschicht 21 aufgebracht werden, bleiben sie nicht nur auf einer dem Grundkörper 4 abgewandten Seite der Deckschicht 21, sondern grundsätzlich auch auf Seitenflächen der Deckschicht 21 haften, siehe Figur 6. Die Seitenflächen der Deckschicht 21 erstrecken sich beispielsweise im Wesentlichen senkrecht zu einer Haupterstreckungsebene der Deckschicht 21.

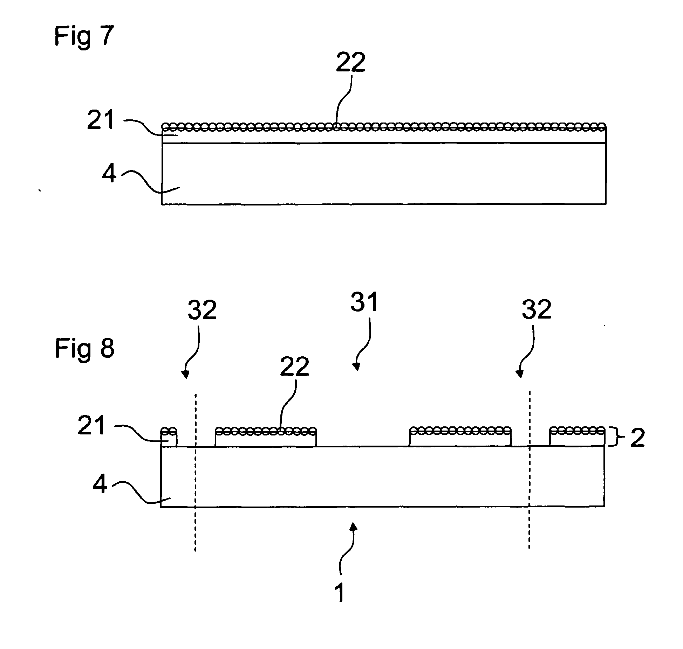

Das in Figur 7 veranschaulichte Verfahrensstadium eines zweiten Ausführungsbeispiels entspricht einem in Figur 5 oder 6 veranschaulichten Verfahrensstadium des ersten Ausführungsbeispiels. Die Partikel des Leuchtstoffes 22 sind vor dem Ausbilden der mindestens einen Kavität 31, 32 auf die Deckschicht 21 aufgebracht.

Nachfolgend werden Kavitäten 31, 32 mittels Photostrukturieren der Deckschicht ausgebildet, siehe Figur 8. Das Photostrukturieren kann beispielsweise nach dem Härten der Deckschicht 21 erfolgen. Alternativ ist es auch möglich, dass die Deckschicht 21 mit dem darauf aufgebrachten Leuchtstoff 22 vor dem Härten strukturiert wird. Da die mindestens eine Kavität 31, 32 erst nach dem Aufbringen des Leuchtstoffes 22 ausgebildet wird, sind Partikel des Leuchtstoffes 22 im Wesentlichen nur auf einer der Deckschicht abgewandten Seite des Grundkörpers 4 angeordnet. Die Deckschicht 21 und der Leuchtstoff 22 bilden ein Lumineszenzkonversionsmaterial 2.

Es ist bei allen Ausführungsbeispielen auch möglich, dass die Partikel des Leuchtstoffes 22 den Grundkörper 4 zumindest teilweise berühren. Dies kann beispielsweise dann der Fall sein, wenn der Mediandurchmesser d₅₀ der Leuchtstoffpartikel größer ist als die Maximaldicke der Deckschicht 21.

Nachfolgend kann der Grundkörper zu einer Vielzahl von Lumineszenzdiodenchips 1 vereinzelt werden, analog zu dem ersten Ausführungsbeispiel.

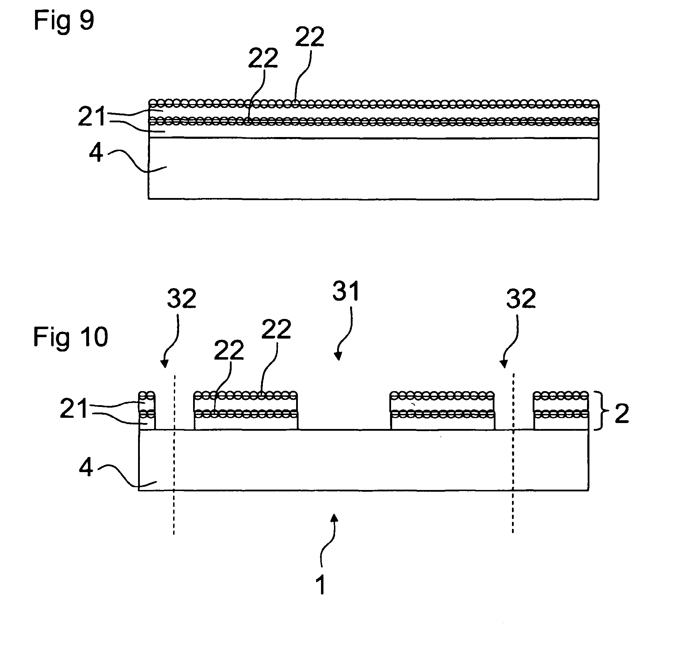

In den Figuren 9 und 10 ist ein drittes Ausführungsbeispiel veranschaulicht. Bei diesen wird eine weitere Deckschicht 21 auf die Leuchtstoffpartikel 22 aufgebracht. Zusätzlich kann auf die weitere Deckschicht 21 eine weitere Leuchtstoffschicht 22 aufgebracht werden. Die weitere Leuchtstoffschicht 22 kann beispielsweise den gleichen Leuchtstoff wie die erste Leuchtstoffschicht aufweisen. Es ist jedoch auch möglich, dass die weitere Leuchtstoffschicht 22 zusätzlich oder alternativ andere Leuchtstoffe aufweist, beispielsweise Leuchtstoffe mit einem anderen Emissionsspektrum oder einem anderen Anregunsspektrum.

Alternativ zu dem in Figur 9 und 10 veranschaulichten Ausführungsbeispiel kann das Aufbringen einer Deckschicht 21 und das Aufbringen von Leuchtstoff 22 auf der Deckschicht 21 auch mehr als zweimal in abwechselnder Reihenfolge erfolgen. Beispielsweise können diese Verfahrensschritte drei Mal oder öfter abwechselnd durchgeführt werden. Dadurch kann der Leuchtstoff 22 kontrolliert und homogen aufgebracht werden. Die Menge an aufgebrachtem Leuchtstoff 22 lässt sich so mit Vorteil präzise einstellen. Die Deckschichten 21 und die Anordnungen von Leuchtstoff 22 bilden ein Lumineszenzkonversionsmaterial 2 oder mehrere Lumineszenzkonversionsmaterialien.

Alternativ lassen sich auf diese Weise wohl definierte Kombinationen verschiedener Leuchtstoffe auf technisch einfache Weise realisieren.

## Patentansprüche

1. Verfahren zum Herstellen mindestens eines Lumineszenzdiodenchips, der mit einem Lumineszenzkonversionsmaterial versehen ist, das mindestens einen Leuchtstoff aufweist, wobei der Leuchtstoff in Form von Leuchtstoffpartikeln vorliegt, mit den Schritten:
- Bereitstellen eines Grundkörpers, der eine Schichtenfolge für den Lumineszenzdiodenchip aufweist, die geeignet ist, eine elektromagnetische Strahlung zu emittieren;
- Aufbringen einer photostrukturierbaren Deckschicht auf zumindest eine Hauptfläche des Grundkörpers;
- Einbringen von mindestens einer Kavität in die Deckschicht mittels Photostrukturieren;
- Aufbringen von mindestens einem Leuchtstoff auf die Deckschicht, wobei der Leuchtstoff gegen die Deckschicht gepresst wird; und
- Ausbilden oder Verstärken einer Haftung zwischen zumindest einem Teil des Leuchtstoffs und der Deckschicht.

2. Verfahren nach Anspruch 1,
wobei das Pressen nach dem Aufbringen erfolgt.

3. Verfahren nach Anspruch 1 oder 2,
wobei die Deckschicht in Form eines flüssigen, härtbaren
Stoffs aufgebracht und das Ausbilden oder Verstärken der Haftung zwischen dem Leuchtstoff und der Deckschicht ein Härten der Deckschicht umfasst.

4. Verfahren nach einem der Ansprüche 1 bis 3,
wobei der Leuchtstoff Leuchtstoffpartikel aufweist, von denen
nach dem Pressen zumindest ein Teil nicht von der Deckschicht eingeschlossen wird.

5. Verfahren nach einem der Ansprüche 1 bis 4,
wobei der Grundkörper für eine Mehrzahl von
Lumineszenzdiodenchips vorgesehen ist.

6. Verfahren nach Anspruch 5,
wobei der Grundkörper ein Wafer oder ein Träger ist, auf dem
die Schichtenfolge oder mehrere derartiger Schichtenfolgen aufgebracht sind.

7. Verfahren nach einem der vorhergehenden Ansprüche, wobei die Deckschicht mittels Spin-Coating aufgebracht wird.

8. Verfahren nach einem der vorhergehenden Ansprüche, wobei die Deckschicht mindestens ein Element aus der Gruppe
bestehend aus Spin-On-Glas, Benzocyclobuten und Polyimid aufweist.

9. Verfahren nach einem der vorhergehenden Ansprüche, wobei die Deckschicht mindestens ein Element aus der Gruppe
bestehend aus Silikon und Siloxan aufweist.

10. Verfahren nach einem der vorhergehenden Ansprüche, wobei mindestens eine weitere photostrukturierbare
Deckschicht auf den Leuchtstoff aufgebracht wird.

11. Verfahren nach Anspruch 10,
wobei auf die weitere Deckschicht ebenfalls der Leuchtstoff
und/oder mindestens ein weiterer Leuchtstoff aufgebracht wird.

12. Verfahren nach einem der vorhergehenden Ansprüche, wobei das Aufbringen der photostrukturierbaren Deckschicht
und des Leuchtstoffs mehrfach abwechselnd erfolgt.

13. Verfahren nach einem der vorhergehenden Ansprüche, wobei die Deckschicht mit einer maximalen Dicke von größer
als 1 µm und kleiner als oder gleich 40 µm ausgebildet wird.

14. Verfahren nach einem der vorhergehenden Ansprüche, wobei der Leuchtstoff in Form von Leuchtstoffpartikeln mit
einem Mediandurchmesser d₅₀ von größer als oder gleich 2 µm und kleiner als oder gleich 20 µm vorliegt.

15. Lumineszenzdiodenchip, der durch ein Verfahren gemäß einem der Ansprüche 1 bis 14 hergestellt ist.

## Claims

1. Method for producing at least one luminescence diode chip provided with a luminescence conversion material comprising at least one phosphor, wherein the phosphor is present in the form of phosphor particles, comprising the following steps:
- providing a main body having a layer sequence for the luminescence diode chip that is suitable for emitting electromagnetic radiation;
- applying a photopatternable cover layer to at least one main surface of the main body;
- introducing at least one cavity into the cover layer by means of photopatterning;
- applying at least one phosphor to the cover layer, wherein the phosphor is pressed against the cover layer;
- forming or reinforcing an adhesion between at least one portion of the phosphor and the cover layer.

2. Method according to Claim 1,
wherein pressing takes place after applying.

3. Method according to Claim 1 or 2,
wherein the cover layer is applied in the form of a liquid, curable substance and forming or reinforcing the adhesion between the phosphor and the cover layer comprises curing the cover layer.

4. Method according to any of Claims 1 to 3, wherein the phosphor comprises phosphor particles, at least one portion of which is not enclosed by the cover layer after pressing.

5. Method according to any of Claims 1 to 4, wherein the main body is provided for a plurality of luminescence diode chips.

6. Method according to Claim 5,
wherein the main body is a wafer or a carrier on which the layer sequence or a plurality of such layer sequences is/are applied.

7. Method according to any of the preceding claims, wherein the cover layer is applied by means of spin-coating.

8. Method according to any of the preceding claims, wherein the cover layer comprises at least one element from the group consisting of spin-on glass, benzocyclobutene and polyimide.

9. Method according to any of the preceding claims, wherein the cover layer comprises at least one element from the group consisting of silicone and siloxane.

10. Method according to any of the preceding claims, wherein at least one further photopatternable cover layer is applied to the phosphor.

11. Method according to Claim 10,
wherein the phosphor and/or at least one further phosphor are/is likewise applied to the further cover layer.

12. Method according to any of the preceding claims, wherein the photopatternable cover layer and the phosphor are applied multiply alternately.

13. Method according to any of the preceding claims, wherein the cover layer is formed with a maximum thickness of greater than 1 µm and less than or equal to 40 µm.

14. Method according to any of the preceding claims, wherein the phosphor is present in the form of phosphor particles having a median diameter d₅₀ of greater than or equal to 2 µm and less than or equal to 20 µm.

15. Luminescence diode chip produced by a method according to any of Claims 1 to 14.

## Revendications

1. Procédé de fabrication d'au moins une puce de diode électroluminescente qui est munie d'un matériau de conversion de luminescence, comprenant au moins un matériau luminescent, dans lequel le matériau luminescent est présent sous la forme de particules de matériau luminescent, comportant les étapes consistant à :
- fournir un corps de base qui comprend une série de couches destinées à la puce de diode électroluminescente qui est conçue pour émettre un rayonnement électromagnétique ;
- déposer une couche de recouvrement pouvant être soumise à une photo-structuration sur au moins une surface principale du corps de base ;
- introduire au moins une cavité dans la couche de recouvrement au moyen d'une photo-structuration ;
- déposer au moins un matériau luminescent sur la couche de recouvrement, le matériau luminescent étant comprimé contre la couche de recouvrement ; et
- créer ou amplifier une adhérence entre moins une partie du matériau luminescent et la couche de recouvrement.

2. Procédé selon la revendication 1, dans lequel la compression s'effectue après le dépôt.

3. Procédé selon la revendication 1 ou 2, dans lequel la couche de recouvrement est déposée sous la forme d'un matériau liquide durcissable et la création ou l'amplification de l'adhérence entre le matériau luminescent et la couche de recouvrement comprend un durcissement de la couche de recouvrement.

4. Procédé selon l'une quelconque des revendications 1 à 3, dans lequel le matériau
luminescent comprend des particules de matériau luminescent dont au moins une partie n'est pas incluse dans la couche de recouvrement après la compression.

5. Procédé selon l'une quelconque des revendications 1 à 4, dans lequel le corps de base est prévu pour une pluralité de puces de diodes électroluminescentes.

6. Procédé selon la revendication 5, dans lequel le corps de base est une plaquette ou un support sur lequel sont déposées la série de couches ou une pluralité de séries de couches de ce type.

7. Procédé selon l'une quelconque des revendications précédentes, dans lequel la couche de recouvrement est déposée par dépôt à la tournette.

8. Procédé selon l'une quelconque des revendications précédentes, dans lequel la couche de recouvrement comprend au moins un élément du groupe constitué par un verre déposé par centrifugation, le benzocyclobutène et un polyimide.

9. Procédé selon l'une quelconque des revendications précédentes, dans lequel la couche de recouvrement comprend au moins un élément du groupe constitué du silicium et du siloxane.

10. Procédé selon l'une quelconque des revendications précédentes, dans lequel au moins une autre couche de recouvrement pouvant être soumise à une photo-structuration est déposée sur le matériau luminescent.

11. Procédé selon la revendication 10, dans lequel le matériau luminescent et/ou au moins un autre matériau luminescent est également déposé sur l'autre couche de recouvrement.

12. Procédé selon l'une quelconque des revendications précédentes, dans lequel le dépôt de la couche de recouvrement pouvant être soumise à une photo-structuration et du matériau luminescent s'effectue plusieurs fois de manière alternée.

13. Procédé selon l'une quelconque des revendications précédentes, dans lequel la couche de recouvrement est réalisée de manière à avoir une épaisseur maximale supérieure à 1 µm et inférieure ou égale à 40 µm.

14. Procédé selon l'une quelconque des revendications précédentes, dans lequel le matériau luminescent est présent sous la forme de particules de matériau luminescent ayant un diamètre moyen d₅₀ supérieur ou égal à 2 µm et inférieur ou égal à 20 µm.

15. Puce de diode électroluminescente qui est fabriquée par un procédé selon l'une quelconque des revendications 1 à 14.
